(19) Europäisches Patentamt
European Patent Office
Office européen des brevets

(11) Veröffentlichungsnummer: **0 399 190 A1**

# (12) EUROPÄISCHE PATENTANMELDUNG

(21) Anmeldenummer: **90106669.6**

(22) Anmeldetag: **06.04.90**

(51) Int. Cl.5: **C07F 5/00, //C23C14/00, C23C16/00**

Die Bezeichnung der Erfindung wurde geändert (Richtlinien für die Prüfung im EPA, A-III, 7.3).

(30) Priorität: **21.04.89 DE 3913165**

(43) Veröffentlichungstag der Anmeldung: **28.11.90 Patentblatt 90/48**

(84) Benannte Vertragsstaaten: **DE FR GB NL**

(71) Anmelder: **MERCK PATENT GESELLSCHAFT MIT BESCHRÄNKTER HAFTUNG**
**Frankfurter Strasse 250**
**D-6100 Darmstadt(DE)**

(72) Erfinder: **Pohl, Ludwig, Dr.**
**Niebergallweg 5**
**D-6100 Darmstadt(DE)**
Erfinder: **Hostalek, Martin, Dr.**
**Wenzelweg 7**
**D-6100 Darmstadt(DE)**
Erfinder: **Benz, Beate, Dr.**
**Mühltalstrasse 71D**
**D-6100 Darmstadt(DE)**
Erfinder: **Schumann, Herbert, Prof.Dr.**
**Weberstrasse 3**
**D-1000 Berlin 49(DE)**
Erfinder: **Hartmann, Uwe**
**Alt Tegel 33**
**D-1000 Berlin 20(DE)**
Erfinder: **Wassermann, Wilfried**
**Krumme Strasse 25**
**D-1000 Berlin 12(DE)**

## (54) Organometallische Aluminium-, Gallium- und Indiumverbindungen zur Herstellung von Halbleitern und ihre Verwendung.

(57) Die Erfindung betrifft metallorganische Verbindungen des Aluminiums, Galliums und Indiums, die intramolekular stabilisiert sind, sowie deren Verwendung zur Herstellung dünner Filme oder epitaktischer Schichten durch Gasphasenabscheidung.

EP 0 399 190 A1

## Metallorganische Verbindungen

Die Erfindung betrifft metallorganische Verbindungen, die Aluminium, Gallium oder Indium als Metalle enthalten, sowie deren Verwendung für die Abscheidung dünner Filme oder epitaktischer Schichten aus der Gasphase.

Die Abscheidung solcher Schichten aus entweder reinen Elementen der III. Gruppe oder aus III-V-Kombinationen, wie z.B. Galliumarsenid, Indiumphosphid oder Galliumphosphid, kann zur Herstellung von elektrischen, elektronischen, optischen und optoelektronischen Schaltelementen, Verbindungshalbleitern und Lasern verwendet werden. Die Abscheidung dieser Schichten erfolgt aus der Gasphase.

Die Eigenschaften dieser Filme hängen von den Abscheidungsbedingungen und der chemischen Zusammensetzung des abgeschiedenen Films ab.

Für die Abscheidung aus der Gasphase kommen alle bekannten Methoden wie die Metal-Organic Chemical Vapour Deposition (MOCVD) Methode, die Photo-Metal-Organic Vapour Phase (Photo-MOVP) Methode, bei welcher die Substanzen durch UV-Bestrahlung zersetzt werden, die Laser Chemical Vapour Deposition (Laser CVD) Methode oder die Metal-Organic Magnetron Sputtering (MOMS) Methode in Frage. Die Vorteile gegenüber anderen Methoden sind ein kontrollierbares Schichtenwachstum, eine genaue Dotierungskontrolle sowie eine aufgrund der Normal- oder Niederdruckbedingungen einfache Handhabung und Produktionsfreundlichkeit.

Bei der MOCVD-Methode werden metallorganische Verbindungen eingesetzt, die sich unter Abscheidung des Metalls bei einer Temperatur unterhalb 1100 °C zersetzen. Typische Apparaturen, die zur Zeit für MOCVD benutzt werden, bestehen aus einem "bubbler" mit einer Zufuhr für die metallorganische Komponente, einer Reaktionskammer, die das zu beschichtende Substrat enthält, sowie einer Quelle für ein Trägergas, das gegen die metallorganische Komponente inert sein soll. Der "bubbler" wird auf einer konstanten, relativ niedrigen Temperatur gehalten, die vorzugsweise über dem Schmelzpunkt der metallorganischen Verbindung, aber weit unterhalb der Zersetzungstemperatur liegt. Die Reaktions- oder Zersetzungskammer hat vorzugsweise eine sehr viel höhere Temperatur, die unterhalb 1100 °C liegt, bei welcher die metallorganische Verbindung sich vollständig zersetzt und das Metall abgeschieden wird. Durch das Trägergas wird die metallorganische Verbindung in den Dampfzustand gebracht und mit dem Trägergas in die Zersetzungskammer geschleust. Der Massenfluß des Dampfes ist gut zu kontrollieren, und somit ist auch ein kontrolliertes Wachsen der dünnen Schichten möglich.

Bislang wurden für die Gasphasenabschei dung hauptsächlich Metallalkyle wie z.B. Trimethylgallium, Trimethylaluminium oder Trimethylindium verwendet. Diese Verbindungen sind jedoch extrem luftempfindlich, selbstentzündlich und teilweise bereits bei Raumtemperatur zersetzlich. Daher sind für die Herstellung, den Transport, die Lagerung und die Anwendung dieser Verbindungen aufwendige Vorsichtsmaßnahmen notwendig. Es sind auch einige, etwas stabilere Addukte der Metallalkyle mit Lewisbasen wie z.B. Trimethylamin und Triphenylphosphin bekannt (z.B. beschrieben in GB 21 23 422, EP-A 108 469 oder EP-A 176 537), die jedoch aufgrund des geringen Dampfdruckes nur bedingt für die Gasphasenabscheidung geeignet sind. Die geringen Dampfdrucke sind oftmals auf das Vorliegen von Dimeren, Trimeren oder Polymeren zurückzuführen.

Aufgabe der vorliegenden Erfindung war es nun, metallorganische Verbindungen zu finden, die einfach handhabbar und bei Raumtemperatur stabil sind und die einen genügend hohen Dampfdruck besitzen, so daß sie für die verschiedenen Methoden der Gasphasenabscheidung geeignet sind.

Es wurde nun gefunden, daß metallorganische Verbindungen von Aluminium, Gallium und Indium, die intramolekular stabilisiert sind, hervorragend für die Gasphasenabscheidung geeignet sind.

Ähnliche Verbindungen sind aus der DE-OS 36 31 469 bekannt. Die dort beschriebenen Verbindungen haben jedoch stets nur ein Donoratom im Molekül, wahrend die erfindungsgemäßen Verbindungen stets mindestens zwei Donoratome im molekül aufweisen.

Gegenstand der Erfindung sind somit die metallorganischen Verbindungen der Formel I

$(R^1)_{3-m}M(X\text{-}Y)_m$ I

worin

m 2 oder 3,

M Aluminium, Gallium oder Indium,

Y a) ein 5- oder 6gliedriger heterocyclischer Ring, wobei das (die) Heteroatom(e) aus der 5. Hauptgruppe stammen,

$-NR^3R^4$, $-PR^3R^4$, $-ASR^3R^4$, $-SbR^3R^4$,

b) -F oder eine Perfluoralkylgruppe mit 1-7 C-Atomen,

X $o\text{-}(CH_2)_p\text{-}C_6H_4\text{-}(CH_2)_q\text{-}$,

$1,2-(CH_2)_p-C_6H_{10}-(CH_2)_q-$,
$1,2-(CH_2)_p-C_6H_8-(CH_2)_q-$,
$1,2-(CH_2)_p-C_6H_6-(CH_2)_q-$,
$1,2-(CH_2)_p-C_5H_8-(CH_2)_q-$,
$1,2-(CH_2)_p-C_5H_6-(CH_2)_q-$,
$1,2-(CH_2)_p-C_5H_4-(CH_2)_q-$,
$1,2-(CH_2)_p-C_4H_6-(CH_2)_q-$,
oder, wenn y die Bedeutung von a) hat, X auch $-(CHR^2)_n-$ mit
n 1, 2, 3, 4 oder 5,
$R^2$ jeweils H oder eine Alkylgruppe mit 1-7 C-Atomen, die auch teilweise oder vollständig fluoriert sein kann,
p und q jeweils unabhängig voneinander 0, 1, 2 oder 3, und
$R^1$, $R^3$ und $R^4$ jeweils unabhängig voneinander H, eine Alkylgruppe oder Alkenylgruppe mit bis zu 8 C-Atomen, wobei diese Gruppen teilweise oder vollständig fluoriert sein können, eine Cycloalkyl- oder Cycloalkenylgruppe mit 3-8 C-Atomen oder eine Arylgruppe,
sowie die Verwendung dieser Substanzen zur Abscheidung des Metalls der III. Hauptgruppe (M) oder der III-V-Kombination aus der Gasphase auf Substraten.

Ferner ist Gegenstand der Erfindung ein Verfahren zur Herstellung dünner Filme und epitaktischer Schichten durch Gasphasenabscheidung des Metalls der III B-Gruppe oder der III-V-Kombination aus metallorganischen Verbindungen, bei welchem als metallorganische Substanzen die Verbindungen der Formel I eingesetzt werden. Ferner ist Gegenstand der Erfindung, daß man bei dem erfindungsgemäßen Verfahren zur herstellung von z.B. Verbindungshalbleitern während des Abscheidungsprozesses eine oder mehrere unter den angewandten Reaktionsbedingungen gasförmige Verbindungen des Arsens, Antimons oder Phosphors zusetzt.

Die Verbindungen der Formel I sind intramolekular stabilisiert durch Elektronenübertragung von den Stickstoff-, Phosphor-, Arsen-, Fluor- oder Antimonatomen (Donoratome) auf das elektronenarme III B-Element. Sie sind daher stabil gegenüber Luft und Sauerstoff, nicht mehr selbstentzündlich und damit einfach zu handhaben. Die Verbindungen der Formel I enthalten zwei oder drei Donoratome.

In der Gasphase jedoch lassen sich die erfindungsgemäßen Verbindungen leicht unter Abscheidung des Metalls zersetzen. Da die Verbindungen der Formel I stabile und gut abspaltbare Abgangsgruppen enthalten, resultiert ein geringerer Einbau an Kohlenstoff, was für die Qualität der Endprodukte große Vorteile hat.

Die abgeschiedenen Filme können sowohl aus dem reinen III B-Element, als auch aus Kombination mit Elementen der V. Gruppe auf beliebigen Substraten gebildet werden. Sie können je nach Substrat und Abscheidetechnik epitaktischer Natur sein.

In Formel I bedeutet M Aluminium (Al), Gallium (Ga) oder Indium (In), vorzugsweise Ga oder In.

m bedeutet vorzugsweise 2.

Y bedeutet in erster Linie bevorzugt $-NR^3R^4$, in zweiter Linie bevorzugt $-PR^3R^4$ oder $-AsR^3R^4$.

Des weiteren stellt Y bevorzugt Fluor oder eine Perfluoralkylgruppe mit 1-4 C-Atomen dar, und bedeutet demnach bevorzugt Trifluormethyl, Pentafluorethyl, Heptafluorpropyl, Nonafluorbutyl, Undecafluorpentyl, Tridecafluorhexyl oder Pentadecafluorheptyl.

Ferner kann Y auch ein 5- oder 6gliedriger heterocyclischer Ringe mit einem oder mehreren Atom(en) der 5. Hauptgruppe, wie N, P oder As, sein. Insbesondere sind folgende Ringe (1) bis (5) bevorzugt:

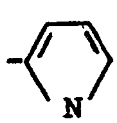
(1)

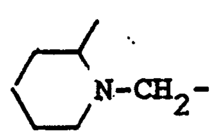
(2)

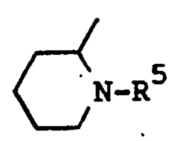
(3)

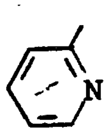
(4)

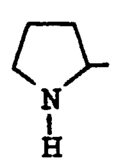
(5)

wobei $R^5$ H oder einen Alkylrest mit 1-8 C-Atomen bedeutet.

In Formel I bedeutet X vorzugsweise $-(CHR^2)_n-$ mit n = 1, 2, 3, 4 oder 5, vorzugsweise ist n = 2, 3 oder 4. $R^2$ stellt entweder ein H-Atom oder eine Alkylgruppe dar, die auch teilweise oder vollständig fluoriert sein kann, mit bis zu 7 C-Atomen und bedeutet demnach vorzugsweise Methyl, Ethyl, Propyl, Butyl, Trifluormethyl, Tetrafluorethyl, Pentafluorethyl oder Heptafluorpropyl. Falls $R^2$ eine Alkyl- oder teilweise oder vollständig fluorierte Alkylgruppe ist, so ist vorzugsweise nur ein $R^2$ in $-(CHR^2)_n-$eine Alkylgruppe, die anderen, eventuell vorhandenen $R^2$ bedeuten dann H.

Ferner sind Verbindungen der Formel I bevorzugt, worin X die Bedeutung o-$(CH_2)_p$-$C_6H_4$-$(CH_2)_q$-, 1,2-$(CH_2)_p$-$C_6H_{10}$-$(CH_2)_q$- oder 1,2-$(CH_2)_p$-$C_5H_8$-$(CH_2)_q$- hat, worin p und q jeweils unabhängig voneinander 0, 1, 2 oder 3, vorzugsweise 0, 1 oder 2 bedeuten.

X bedeutet ferner bevorzugt eine der folgenden Gruppierungen (1)-(8) für -X-Y.

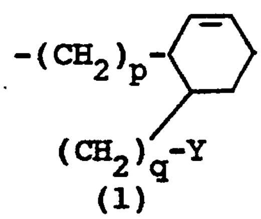
(1) ,

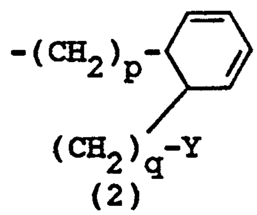
(2) ,

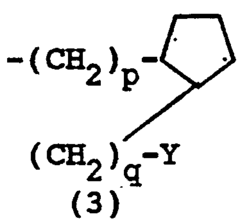
(3) ,

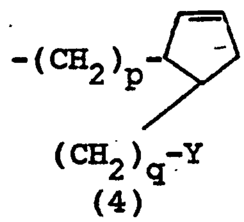
(4) ,

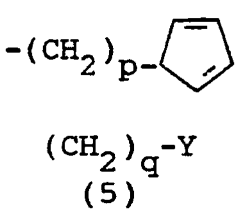
(5) ,

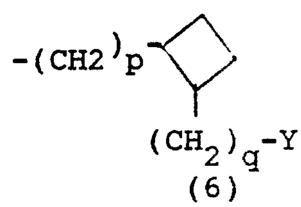
(6) ,

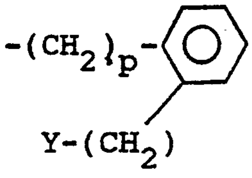
(7) ,

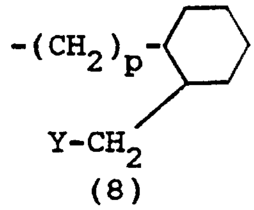
(8) ,

In den Formeln (1), (2), (4) und (5) können die Doppelbindungen auch in allen anderen möglichen Positionen stehen.

p und q in Formel I bedeuten vorzugsweise 1 oder 2. Dabei sind diejenigen Verbindungen bevorzugt, bei denen eine der Gruppen p und q 0 ist und die andere 1 oder 2 bedeutet.

Die Reste $R^1$, $R^3$ und $R^4$ in Formel I bedeuten vorzugsweise jeweils eine geradkettige oder verzweigte Alkylgruppe mit 1-8 C-Atomen, vorzugsweise mit 1-5 C-Atomen. Die Alkylgruppen sind vorzugsweise geradkettig und bedeuten demnach bevorzugt Methyl, Ethyl, Propyl, Butyl, Pentyl, ferner auch Hexyl, Heptyl, Octyl, iso-Propyl, sek.-Butyl, tert.-Butyl, 2-Methylpentyl, 3-Methylpentyl oder 2-Octyl. Die Alkylreste können teilweise oder auch vollständig fluoriert sein und z.B. Monofluormethyl, Difluormethyl, Trifluormethyl, Difluorethyl, Trifluorethyl, Pentafluorethyl oder Trifluorpropyl bedeuten.

Falls $R^1$, $R^3$ und/oder $R^4$ eine Cycloalkyl- oder Cycloalkenylgruppe mit 3-8 C-Atomen bedeuten, so bedeuten sie vorzugsweise Cyclopropyl, Cyclobutyl, Cyclopentyl, Cyclopentenyl, Cyclohexyl, Cyclohexenyl, Cyclohexadienyl, Cycloheptyl, Cycloheptenyl, Cycloheptadienyl, Cyclooctyl, Cyclooctenyl, Cyclooctadienyl, Cyclooctatrienyl oder Cyclooctatetraenyl.

Vorzugsweise stellen $R^1$, $R^3$ und/oder $R^4$ auch Alkenylgruppen mit 3-8 C-Atomen, vorzugsweise mit 3-5 C-Atomen dar. Sie bedeuten demnach vorzusweise Propenyl, Butenyl, Pentenyl ferner Hexenyl, Heptenyl oder Octenyl.

Weiterhin sind Verbindungen der Formel I bevorzugt, worin $R^1$, $R^3$ und/oder $R^4$ Arylgruppen bedeuten. Arylgruppe bedeutet vorzugsweise eine Phenylgruppe. Diese Phenylgruppe kann auch substituiert vorliegen. Da diese Substituenten keinen wesentlichen Einfluß auf den angestrebten Verwendungszweck ausüben, sind alle Substituenten erlaubt, die keinen störenden Einfluß auf die Zersetzungsreaktion haben.

Der Rest (X-Y) kann zweimal oder dreimal auftreten und kann denn unterschiedliche oder gleiche Bedeutung haben. Vorzugsweise hat er die gleiche Bedeutung.

Folgende Verbindungen der Formeln 9-31 stellen eine kleinere Gruppe von besonders bevorzugten Verbindungen der Formel I dar:

$R^1-Al[-(CH_2)_n-NR^3R^4]_2$ 9
$R^1-Ga[-(CH_2)_n-NR^3R^4]_2$ 10
$R^1-In[-(CH_2)_n-NR^3R^4]_2$ 11
$Al[-(CH_2)_n-NR^3R^4]_3$ 12
$Ga[-(CH_2)_n-NR^3R^4]_3$ 13
$In[-(CH_2)_n-NR^3R^4]_3$ 14
$R^1-M[-(CH_2)_n-PR^3R^4]_2$ 15
$R^1-M[-(CH_2)_n-AsR^3R^4]_2$ 16
$M[-(CH_2)_n-PR^3R^4]_3$ 17
$M[-(CH_2)_n-AsR^3R^4]_3$ 18
$R^1M[o-C_6H_4-NR^3R^4]_2$ 19
$R^1-Al[o-C_6H_4-F]_2$ 20
$R^1-Ga[o-C_6H_4-F]_2$ 21
$R^1-In[o-C_6H_4-F]_2$ 22
$Al-[o-C_6H_4-F]_3$ 23
$Ga-[o-C_6H_4-F]_3$ 24
$In-[o-C_6H_4-F]_3$ 25
$R^1-Al[o-C_6H_4-C_2F_5]_2$ 26
$R^1-Ga[o-C_6H_4-C_2F_5]_2$ 27
$R^1-In[o-C_6H_4-C_2F_5]_2$ 28
$R^1-Al[o-C_6H_4-CF_3]_2$ 29
$R^1-Ga[o-C_6H_4-CF_3]_2$ 30
$R^1-In[o-C_6H_{10}-CF_3]_2$ 31

Für die erfindungsgemäße Verwendung der Verbindungen der Formel I ist wesentlich die intramolekulare Stabilisierung, die auf der Bindung zwischen dem Metallatom und den jeweiligen heteroatomen der Gruppe Y, die durch 2, 3, 4 oder 5 C-Atome vom detail getrennt sind, beruht. Durch diese intramolekulare Bindung erhalten die Verbindungen der Formel I im Vergleich zu den freien Metallalkylen eine bedeutend höhere Stabilität gegenüber Luft und Sauerstoff. Sie sind nicht mehr selbstentzündlich und daher einfach und ohne größere Vorsichtsmaßnahmen zu handhaben.

Die Verbindungen der Formel I sind hervorragend für die MOCVD-Epitaxie bzw. MOCVD-Methode geeignet, da sie sich bei höheren Temperaturen unter Freisetzung des entsprechenden Metalles zersetzen. Sie sind ebenfalls für die anderen Methoden der Gasphasenabscheidung wie Photo-MOVP, Laser-CVD oder MOMS geeignet.

Die Verbindungen der Formeln I werden nach an sich bekannten Methoden hergestellt, wie sie in der Literatur (z.B. G. Bähr, P. Burba, Methoden der organischen Chemie, Band XIII/4, Georg Thieme Verlag, Stuttgart (1970)) beschrieben sind, und zwar unter Reaktionsbedingungen, die für die genannten Umsetzungen bekannt und geeignet sind. Dabei kann man auch von an sich bekannten, hier nicht näher erwähnten Varianten Gebrauch machen.

So können Verbindungen der Formel I z.B. hergestellt werden, indem man Metallalkylchloride mit einem Alkalimetallorganyl der entsprechenden Lewisbase oder einer Grignard-Verbindung in einem inerten Lösungsmittel umsetzt.

Die Umsetzungen erfolgen vorzugsweise in inerten Lösungsmitteln. Als Lösungsmittel kommen dabei alle diejenigen in Frage, die die Umsetzung nicht stören und nicht in das Reaktionsgeschehen eingreifen. Die Reaktionstemperaturen entsprechen im wesentlichen denen, die aus der Literatur für die Herstellung ähnlicher Verbindungen bekannt sind.

Beim erfindungsgemäßen Verfahren zur Herstellung dünner Filme oder epitaktischer Schichten auf beliebigen Substraten setzt man bei den an sich bekannten Gasphasenabscheidungs-Prozessen von metallorganischen Verbindungen als Ausgangsverbindungen die stabilisierten metallorganischen Verbindungen der Formel I ein. Die Reaktionsbedingungen können analog den aus der Literatur bekannten und dem Fachmann geläufigen Werten gewählt werden.

Zur Herstellung von Verbindungshalbleitern, elektronischen und optoelektronischen Bauteilen können beim erfindungsgemäßen Verfahren während des Abscheidungsprozesses in der Zersetzungskammer eine oder mehrere unter den angewandten Reaktionsbedingungen gasförmige Verbindungen des Arsens, Antimons oder Phosphors, beispielsweise $AsH_3$, $As(CH_3)_3$, $PH_3$ oder $SbH_3$, zusätzlich zugesetzt werden. Eine weitere Variante des erfindungsgemäßen Verfahrens besteht darin, daß man während des Abscheidungsprozesses zusätzlich zu den erfindungsgemäßen metallorganischen Verbindungen der Formel I Dotierstoffe zusetzt. Als Dotierstoffe werden dabei flüchtige metallorganische Verbindungen von Eisen, Magnesium, Zink oder Chrom eingesetzt. Als bevorzugte Verbindungen gelten dabei z.B. $Zn(CH_3)_2$, $Mg(CH_3)_2$ oder $Fe(C_5H_5)_2$.

Ferner ist es möglich, die Verbindungen der Formel I als Dotierstoffe während des Abscheidungsprozesses anderer metallorganischer Verbindungen zuzusetzen.

Die nach den erfindungsgemäßen Verfahren hergestellten Schichten können verwendet werden für die Herstellung von elektrischen, optischen, elektronischen und optoelektronischen Schaltelementen, Verbindungshalbleitern oder Lasern.

Da bei den momentan im Einsatz befindlichen Epitaxieanlagen aus thermodynamischen Gründen nur ca. 1-10 % der eingesetzten freien Metallalkyle als Epitaxieschicht auf dem Substrat abgeschieden werden kann, stellt die Vernichtung der überschüssigen Metallalkyle, die aufgrund ihrer extremen Empfindlichkeit nicht zurückgewonnen werden können, ein erhebliches Problem dar. Die erfindungsgemäßen Verbindungen der Formel I eröffnen dagegen aufgrund ihrer hohen Stabilität neue Möglichkeiten zur gefahrlosen Vernichtung oder zur Rückgewinnung der wertvollen III B-Verbindungen.

Die folgenden Beispiele sollen die Erfindung näher erläutern. Temperaturangaben erfolgen immer in Grad Celsius. Fp. bedeutet Schmelzpunkt und Kp. Siedepunkt.

## Beispiel 1

Man suspendiert 5 g 3-Dimethylaminopropyllithium (53,7 mmol) in 40 ml Pentan und tropft dazu eine Lösung von 4 g Methylgalliumdichlorid (25,7 mmol) in 20 ml Benzol. Es wird zunächst eine Stunde bei Raumtemperatur gerührt und dann 6 Stunden unter Rückfluß gekocht. Nach der Erkalten wird von Lithiumchlorid und überschüssigem Lithiumsalz gefrittet und das Lösungsmittel im Vakuum abgezogen. Der verbleibende Rückstand wird im Vakuum bei einer Ölbadtemperatur von 60 °C sublimiert. Man erhält Bis-(3-dimethylaminopropyl)methylgallium als weißen Feststoff mit Fp. 52°.

Analog werden hergestellt:

Bis-(3-dimethylaminopropyl)methylindium
Bis-(3-dimethylaminopropyl)methylaluminium
Bis-(3-dimethylaminopropyl)ethylgallium
Bis-(3-dimethylaminopropyl)ethylindium
Bis-(3-dimethylaminopropyl)ethylaluminium
Bis-(3-dimethylaminopropyl)propylgallium
Bis-(3-dimethylaminopropyl)propylindium
Bis-(3-dimethylaminopropyl)propylaluminium
Bis-(3-diethylaminopropyl)methylgallium
Bis-(3-diethylaminopropyl)methylindium
Bis-(3-diethylaminopropyl)methylaluminium
Bis-(3-dimethylaminoethyl)methylgallium
Bis-(3-dimethylaminoethyl)methylindium
Bis-(3-dimethylaminoethyl)methylaluminium
Bis-(3-dimethylaminoethyl)ethylgallium
Bis-(3-dimethylaminoethyl)ethylindium

Bis-(3-dimethylaminoethyl)ethylaluminium
Bis-(3-dimethylaminobutyl)methylgallium
Bis-(3-dimethylaminobutyl)methylindium
Bis-(3-dimethylaminobutyl)methylaluminium
Bis-(3-dimethylaminobutyl)ethylgallium
Bis-(3-dimethylaminobutyl)ethylindium
Bis-(3-dimethylaminobutyl)ethylaluminium.

## Ansprüche

1. Metallorganische Verbindungen der Formel I
$(R^1)_{3-m}M(X-Y)_m$ I
worin
m 2 oder 3,
M Aluminium, Gallium oder Indium,
Y a) ein 5- oder 6gliedriger heterocyclischer Ring, wobei das (die) Heteroatom(e) aus der 5. Hauptgruppe stammen, $-NR^3R^4$, $-PR^3R^4$, $-AsR^3R^4$, $-SbR^3R^4$,
b) -F oder eine Perfluoralkylgruppe mit 1-7 C-Atomen,
X o-$(CH_2)_p$-$C_6H_4$-$(CH_2)_q$-,
1,2-$(CH_2)_p$-$C_6H_{10}$-$(CH_2)_q$-,
1,2-$(CH_2)_p$-$C_6H_8$-$(CH_2)_q$-,
1,2-$(CH_2)_p$-$C_6H_6$-$(CH_2)_q$-,
1,2-$(CH_2)_p$-$C_5H_8$-$(CH_2)_q$-,
1,2-$(CH_2)_p$-$C_5H_6$-$(CH_2)_q$-,
1,2-$(CH_2)_p$-$C_5H_4$-$(CH_2)_q$-,
1,2-$(CH_2)_p$-$C_4H_6$-$(CH_2)_q$-,
oder, wenn Y die Bedeutung von a) hat, X auch $-(CHR^2)_n-$ mit n = 1,2,3,4 oder 5,
$R^2$ jeweils H oder eine Alkylgruppe mit 1-7 C-Atomen, die auch teilweise oder vollständig fluoriert sein kann,
p und q jeweils unabhängig voneinander 0, 1, 2 oder 3,
und
$R^1$, $R^3$ und $R^4$ jeweils unabhängig voneinander H, eine Alkylgruppe oder Alkenylgruppe mit bis zu 8 C-Atomen, wobei diese Gruppen teilweise oder vollständig fluoriert sein können, eine Cycloalkyl- oder Cycloalkenylgruppe mit 3-8 C-Atomen oder eine Arylgruppe, bedeuten.

2. Verwendung der metallorganischen Verbindungen der Formel I nach Anspruch 1 zur Abscheidung des Metalls der III. Hauptgruppe (M) oder einer III-V-Kombination aus der Gasphase auf Substraten.

3. Verwendung der metallorganischen Verbindungen der Formel I nach Anspruch 1 zur Abscheidung epitaktischer Schichten.

4. Verfahren zur Herstellung dünner Filme auf Substraten durch Gasphasenabscheidung aus metallorganischen Verbindungen, dadurch gekennzeichnet, daß als metallorganische Verbindungen die Verbindungen der Formel I nach Anspruch 1 eingesetzt werden.

5. Verfahren nach Anspruch 4, dadurch gekennzeichnet, daß man zur Herstellung von Verbindungshalbleitern, elektrischen, elektronischen, optischen und optoelektronischen Bauteilen während des Abscheidungsprozesses eine oder mehrere unter den angewandten Reaktionsbedingungen gasförmige Verbindungen des Arsens, Antimons oder Phosphors zuführt.

6. Verfahren nach Anspruch 4, dadurch gekennzeichnet, daß man zusätzlich zu den metallorganischen Verbindungen der Formel I während des Abscheidungsprozesses Dotierstoffe zusetzt.

7. Verfahren nach Anspruch 4, dadurch gekennzeichnet, daß die Verbindungen der Formel I nach Anspruch 1 als Dotierstoffe während des Abscheidungsprozesses von anderen metallorganischen Verbindungen zugesetzt werden.

Europäisches Patentamt

# EUROPÄISCHER RECHERCHENBERICHT

Nummer der Anmeldung

EP 90106669.6

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int Cl 5) |
|---|---|---|---|
| D,A | CHEMICAL ABSTRACTS, Band 110, Nr. 20, 15. Mai 1989, Columbus, Ohio, USA A.FOERSTER "Use of high-resolution electron energy-loss spectroscopy for studying semiconductor layer systems" Seite 744, Zusammenfassung-Nr. 183 960 & Ber. Kernforschungsanlage Jülich 1988, Juel-2247 -- | 1,2,5 | C 07 F 5/00<br>//C 23 C 14/00<br>C 23 C 16/00 |
| D,A | EP - B1 - 0 108 469 (THE SECRETARY OF STATE FOR DEFENCE - UK) * Ansprüche; Beispiele * -- | 1,2,5 | |
| D,A | DE - A1 - 3 631 469 (MERCK) * Ansprüche; Beispiele * -- | 1,2,5 | **RECHERCHIERTE SACHGEBIETE (Int. Cl 5)** |
| D,A | GB - A - 2 123 422 (BRITISH TELECOMMUNICATIONS) * Zusammenfassung * ---- | 1,2,5 | C 07 F<br>C 23 C |

Der vorliegende Recherchenbericht wurde für alle Patentansprüche erstellt.

| Recherchenort | Abschlußdatum der Recherche | Prüfer |
|---|---|---|
| WIEN | 16-07-1990 | MARCHART |

KATEGORIE DER GENANNTEN DOKUMENTEN

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument